# Europäisches Patentamt
# European Patent Office
# Office européen des brevets

(11) Veröffentlichungsnummer: **0 060 384**
**B1**

(12) **EUROPÄISCHE PATENTSCHRIFT**

(45) Veröffentlichungstag der Patentschrift:
24.09.86

(21) Anmeldenummer: **82100796.0**

(22) Anmeldetag: **04.02.82**

(51) Int. Cl.⁴: **H 04 B  1/18,** H 03 J  3/18,
H 04 N  5/44

(54) Schaltungsanordnung zur Ankopplung der Antenne an die HF-Eingangsschaltung eines Autorundfunkempfängers.

(30) Priorität: **13.03.81  DE 3109546**

(43) Veröffentlichungstag der Anmeldung:
**22.09.82 Patentblatt 82/38**

(45) Bekanntmachung des Hinweises auf die Patenterteilung:
**24.09.86 Patentblatt 86/39**

(84) Benannte Vertragsstaaten:
**AT DE FR GB IT**

(56) Entgegenhaltungen:
**DE-A-2 909 997
DE-B-2 709 314**

**FUNKSCHAU, Heft 2, 1975, München, FRANZIS-VERLAG GMBH "MOS allerorten", Seiten 40-47
ING. H. HAHN "FET, UJT u. PUT in Theorie u. Praxis", 2. Auflage, 1973, Bad Wörishofen, VERLAG ERWIN GEYER, Seiten 28-32
FUNK-TECHNIK, 31. Jahrgang, Nr. 3, 1976, Heidelberg, HÜTHIG-VERLAG
"Kreuzmodulationsfester Fernseh-Tuner mit FET-VHF-Mischstufe", Seiten 52-54**

(73) Patentinhaber: **GRUNDIG E.M.V. Elektro-Mechanische Versuchsanstalt Max Grundig, Kurgartenstrasse 37, D-8510 Fürth (DE)**

(72) Erfinder: **Niegratschka, Rudolf, Amalienstrasse 85, D-8510 Fuerth/Bayern (DE)**
Erfinder: **Müller, Rudolf, Veitshöchheimer Strasse 18, D-8500 Nürnberg 90 (DE)**

EP 0 060 384 B1

**Beschreibung**

Die Erfindung betrifft eine Anordnung zur Ankopplung der Antenne an die HF-Eingangsschaltung eines Autorundfunkempfängers mit einem durch Kapazitätsdioden abstimmbaren Serienschwingkreis.

Durch die hohe Kapazität der üblicherweise verwendeten Autoantennen mit Anschlußkabel ist eine optimale Ankopplung an den Eingangskreis nicht befriedigend möglich, da durch die relativ geringe Variation der zu verwendenden Abstimmdioden nur eine lose Antennenkopplung möglich ist. Ferner ändert sich die Ankopplung frequenzabhängig. Das hierbei zu erreichende Signal-Rausch-Verhältnis (Empfindlichkeit des Empfängers) liegt bisher bei Geräten der geschilderten Art unter den sonst üblichen Werten.

Es sind verschiedene Anordnungen zur Ankopplung einer Autoantenne an die HF-Eingangsschaltung eines Autorundfunkempfängers bekannt. In einfachster Weise wird das Ankoppeln der Antenne auf eine Anzapfung der Eingangsspule des Eingangskreises vorgenommen. Auch wird das Ankoppeln der Antenne über einen Kondensator oder eine Eingangsinduktivität auf den Hochpunkt des Eingangskreises durchgeführt. Bei Autorundfunkempfängern wird vorwiegend in Verbindung mit einem durch Kapazitätsdioden abgestimmten Eingangskreis meist eine aperiodische Transistorstufe als Koppelelement der Antenne an den Eingangskreis verwendet.

Nachteilig bei einer Ankopplung dieser Art ist die geringe Kreuzmodulationsfestigkeit bedingt durch die breitbandige Aussteuerung des als Verstärker geschalteten Transistore durch das Antennensignal.

Der Erfindung liegt die Aufgabe zugrunde, eine Anordnung zur Ankopplung der Antenne an die HF-Eingangsschaltung eines Autorundfunkempfängers mit einem durch Kapazitätsdioden abstimmbaren Serienschwingkreis zu schaffen, die einen großen Signal-Rausch-Abstand sowie eine hohe Kreuzmodulationsfestigkeit gewährleistet. Diese Aufgabe wird durch das Kennzeichen des Patentanspruchs 1 erfüllt.

In der dargestellten Figur wird das Antenneneingangssignal über einen Koppelkondensator $C_1$ an einen als Übertragungselement dienenden Transistor $T_1$ einer Impedanzwandlerstufe geführt. Im dargestellten Beispiel wird als Übertragungselement ein Feldeffekttransistor verwendet. Der Koppelkondensator $C_1$ liegt hierbei an der Gate-Elektrode $G_1$ des Feldeffekttransistors $T_1$ an. An Punkt 1 wird über einen Widerstand $R_1$ der Gate-Elektrode $G_2$ eine feldstärkeabhängige Kegelspannung $U_R$ zugeführt. Ein Kondensator $C_2$ führt von der Gate-Elektrode $G_2$ nach Masse. Die Source-Elektrode S, die über einen Spannungsteiler $R_2$, $R_3$ an der

Stromversorgung $U_B$ liegt, ist über einen Trennkondensator $C_3$ mit dem Eingangspunkt eines Serienschwingkreises bestehend aus einer Induktivität $L_1$ und einer Kapazitätsdiode $D_1$ verbunden. Die Drain-Elektrode D liegt HF-mäßig neutral direkt an der Versorgungsspannung $U_B$. Über eine Hilfswicklung ist der dem Schwingkreis $L_1$, $D_1$ nachfolgende Schwingkreis $L_2$, $D_2$ so angekoppelt, daß sich hierbei ein als kritisch gekoppeltes Bandfilter ergibt. Um diese kritische Kopplung über den gesamten Übertragungsbereich zu erzielen, ist eine kapazitive Gegenkopplung erforderlich. Vom Hochpunkt des Sekundärkreises $L_2$, $D_2$ wird das HF-Signal über einen als Source-Folger-Stufe geschalteten Feldeffekttransistor $T_2$ an Punkt 2 der nachfolgenden Mischstufe über einen Kondensator $C_4$ Zugeführt. Anstelle des Feldeffekttransistors $T_1$ kann auch ein bipolarer Transistor verwendet werden, und weiterhin kann das HF-Eingangssignal über ein Netzwerk an die Eingangselektrode des Transistors geführt sein. Ebenfalls kann der als Übertragungselement dienende Transistor $T_1$ in ein weitere Schaltkreise einschliegendes integriertes Schaltelement einbezogen sein. An den Serienschwingkreis sind in bekannter Weise weitere Selektionsmittel ankoppelbar. Ein weiterer Vorteil der geschilderten Schaltungsanordnung ist, daß Mehrfachabstimmdioden mit gemeinsamer Masseelektrode verwendbar sind.

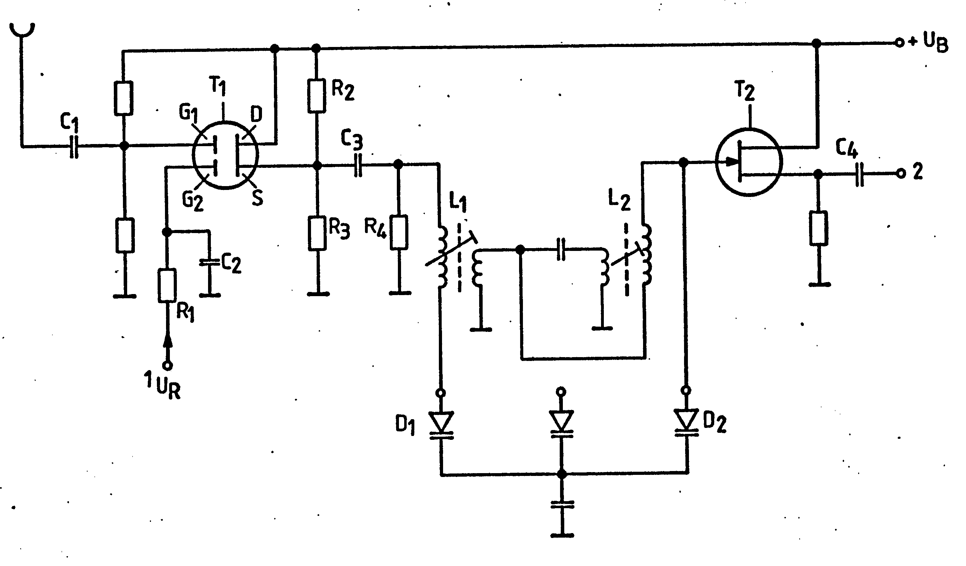

**Patentansprüche**

1. Anordnung zur Ankopplung der Antenne an die HF-Eingangsschaltung eines Autorundfunkempfängers mit einem durch Kapazitätsdioden abstimmbaren Serienschwingkreis, dadurch gekennzeichnet, daß das HF-Eingangssignal einer zur Ankopplung an einen Serienschwingkreis (L1, D1) dienenden Impedanzwandlerstufe (T1) zugeführt wird und daß das von der Impedanzwandlerstufe über einen Koppelkondensator ($C_3$) ausgekoppelte HF-Signal Widerstand ($R_4$) in den Serienschwingkreis (L1, D1) eingespeist wird.

2. Anordnung nach Anspruch 1, dadurch gekennzeichnet, daß die Impedanzwandlerstufe als aktives Element einen Feldeffekttransistor enthält.

3. Anordnung nach Anspruch 1, dadurch gekennzeichnet, daß die Impedanzwandlerstufe als aktives Element einen bipolaren Transistor enthält.

4. Anordnung nach einem oder mehreren der Ansprüche 1 bis 3, dadurch gekennzeichnet, daß das HF-Eingangssignal über ein Netzwerk an die Eingangselektrade des aktiven Elements der Impedanzwandlerstufe geführt ist.

5. Anordnung nach einem oder mehreren der Ansprüche 1 bis 4, dadurch gekennzeichnet, daß an dem Serienschwingkreis weitere Selektionsmittel angekoppelt sind.

6. Anordnung nach einem oder mehreren der Ansprüche 1 bis 5,

dadurch gekennzeichnet, daß das aktive Element der Impedanzwandlerstufe mit in ein integriertes Schaltelement einbezogen ist.

**Claims**

1. Arrangement for coupling the antenna to the RF input circuit of a car radio receiver comprising a series tuned circuit which can be tuned by tuning diodes, characterised in that the RF input signal is supplied to an impedance converter stage (T1) which is used for coupling the signal to a series tuned circuit ($L_1$, $D_1$) and that the RF signal coupled out of the impedance converter stage via a coupling capacitor (C3) is fed into the series tuned circuit (L1, D1) to a resistor (R4).

2. Arrangement according to Claim 1, characterised in that the impedance converter stage contains a field-effect transistor as the active element.

3. Arrangement according to Claim 1, characterised in that the impedance converter stage contains a bipolar transistor as the active element.

4. Arrangement according to one or more of Claims 1 to 3, characterised in that the RF input signal is conducted via a network to the input electrode of the active element of the impedance converter stage.

5. Arrangement according to one or more of Claims 1 to 4, characterised in that further selection means are coupled to the series tuned circuit.

6. Arrangement according to one or more of Claims 1 to 5, characterised in that the active element of the impedance converter stage is incorporated in an integrated contact element.

**Revendications**

1. Dispositif pour coupler l'antenne au circuit d'entrée H.F. d'un récepteur de radiodiffusion pour automobiles qui comprend un circuit oscillant série accordé par diodes capacitives, caractérisé en ce que le signal d'entrée H.F. est envoyé à un étage changeur d'impédance ($T_1$) qui sert au couplage à un circuit oscillant série ($L_1$, $D_1$) et en ce que le signal H.F. découplé de l'étage changeur d'impédance transmis par un condensateur de couplage ($C_3$) est injecté dans le circuit oscillant série ($L_1$, $D_1$) au niveau d'une résistance ($R_4$).

2. Dispositif selon la revendication 1, caractérisé en ce que l'étage changeur d'impédance comprend comme élément actif un transistor à effet de champ.

3. Dispositif selon la revendication 1, caractérisé en ce que l'étage changeur d'impédance comprend comme élément actif un transistor bipolaire.

4. Dispositif selon l'une ou plusieurs des revendications 1 à 3, caractérisé en ce que le signal d'entrée H.F. est transmis par un circuit à l'électrode d'entrée de l'élément actif de l'étage changeur d'impédance.

5. Dispositif selon une ou plusieurs des revendications 1 à 4 caractérisé en ce que d'autres moyens de sélection sont couplés au circuit oscillant série.

6. Dispositif selon une ou plusieurs des revendications 1 à 5 caractérisé en ce que l'élément actif de l'étage changeur d'impédance est incorporé à un composant intégré.